# EUROPÄISCHE PATENTANMELDUNG

(11) **EP 2 101 359 A2**
(43) Veröffentlichungstag der Anmeldung: **16.09.2009**
(21) Anmeldenummer: 09003163.4
(22) Anmeldetag: 05.03.2009
(51) Int. Cl.: H01L 31/18, H01L 27/142, B23K 26/04, B23K 26/40, B23K 26/08

(54) **Verfahren zur Bildung der Trennlinien eines photovoltaischen Moduls mit serienverschalteten Zellen mittels einem Laserscanner**

(30) Priorität: 13.03.2008 DE 102008014258
(71) Anmelder: SCHOTT Solar AG, 55122 Mainz (DE)
(72) Erfinder: Psyk, Walter, 81371 München (DE)
(74) Vertreter: Haft, von Puttkamer, Berngruber

(57) **Zusammenfassung**

Zur Bildung der Trennlinien (5, 6, 7), die bei der Herstellung eines photovoltaischen Moduls mit serienverschalteten Zellen (C1, C2, ...) in den auf einem transparenten Substrat (1) abgeschiedene Funktionsschichten (2, 3, 4) erzeugt werden, wird wenigstens ein Laserscanner (8) verwendet, dessen Laserstrahl (14) in dem von ihm abgetastetem Feld (17) mehrere nebeneinander angeordnete Trennlinienabschnitte (18, 18') in der Funktionsschicht (2, 3, 4) erzeugt. Der Laserscanner (8) wird relativ zu dem beschichteten Substrat (1) in Richtung (Y) der Trennlinien (5, 6, 7) bewegt, wodurch eine Überlappung (36) benachbarter Felder (17, 17') entsteht. Dabei werden mit dem Laserscanner (8) Trennlinienabschnitte (18, 18') erzeugt, die zumindest an einem Ende (32) hakenförmig ausgebildet sind, sodass ein Fangbereich gebildet wird, in dem sich die Enden (31, 32) der Trennlinienabschnitte (18, 18') benachbarter Felder (17, 17') überlappen.

## Beschreibung

Die Erfindung bezieht sich auf ein Verfahren nach dem Oberbegriff des Anspruchs 1. Ein derartiges Verfahren ist aus WO 2007/144565 A2 bekannt. Damit sich durchgehende Trennlinien aus den Trennlinienabschnitten der benachbarten Felder ergeben, ist eine hohe Genauigkeit der Kalibrierung der Felder sowie aller Komponenten der Strukturierungsvorrichtung erforderlich.

Die Trennlinien in der jeweiligen Funktionsschicht sollen die benachbarten Teilbereiche dieser Schicht elektrisch voneinander trennen. Wenn beispielsweise durch ungenaue Justage der Strukturierungsvorrichtung die Trennlinienabschnitte in einem Feld sich mit den Trennlinienabschnitten in dem benachbarten Feld nicht überlappen, bilden sich Lücken in der aus den einzelnen Trennlinienabschnitten zusammengesetzten (langen) Trennlinie, sodass ihre Funktion fehlerhaft wird und damit die Serienverschaltung der benachbarten Zellen des photovoltaischen Moduls defekt bzw. die einzelnen Zellen elektrisch kurzgeschlossen werden.

Aus DE 10 2006 051 555 A1 und EP 0 482 240 A1 sind Verfahren bekannt, bei denen Trennlinien an bereits eingebrachten Trennlinien ausgerichtet werden.

Aufgabe der Erfindung ist es, eine Überlappung der Trennlinienabschnitte benachbarter Felder sicherzustellen.

Dies wird erfindungsgemäß mit dem im Anspruch 1 gekennzeichneten Verfahren erreicht. In den Unteransprüchen sind vorteilhafte Ausgestaltungen des erfindungsgemäßen Verfahrens wiedergegeben. Nach der Erfindung werden mit dem Laserscanner Trennlinienabschnitte erzeugt, die zumindest an einem Ende hakenförmig ausgebildet sind, sodass sich ein Fangbereich bildet, in dem sich die Enden der Trennlinien benachbarter Felder überlappen.

Statt einer geradlinigen Form der Trennlinienabschnitte nach der eingangs erwähnten Patentanmeldung weichen erfindungsgemäß die Trennlinienabschnitte damit zumindest an einem Ende von der geradlinigen Form ab. Alternativ können auch beide Enden jedes Trennlinienabschnitts hakenförmig ausgebildet sein. Die hakenförmigen Abschnitte können beispielsweise abgewinkelt oder gekrümmt sein.

Außerdem überlappen sich erfindungsgemäß die Felder in Richtung der Trennlinie. Damit die Genauigkeitsanforderungen in diesen Überlappungszonen in größeren Toleranzen definiert werden können und auch die Toleranzen für das ganze Strukturierungssystem größer sein können, kann beispielsweise der Anfang jedes Trennlinienabschnittes eines Feldes als Fangbereich für den zuvor gelaserten Trennlinienabschnitt des benachbarten Feldes ausgeführt werden.

Wenn erfindungsgemäß ein Ende jedes Trennlinienabschnitts als Fangbereich, also hakenförmig gestaltet ist, können damit Fehler in der Justage des Strukturierungssystems ausgeglichen werden.

Mit der Erfindung ist damit sichergestellt, dass der Anfang eines Trennlinienabschnittes das Ende des Trennlinienabschnitts des benachbarten Feldes schneidet bzw. überlappt.

Vorzugsweise liegt in Querrichtung der Trennlinie der Scheitelpunkt des Hakens auf der einen und die Spitze des Hakens auf der anderen Seite des geraden Trennlinienabschnitts. Die Breite des hakenförmigen Abschnitts sollte mindestens das zweifache, vorzugsweise das zwei- bis vierfache der Breite der Trennlinie betragen und die Länge des hakenförmigen Abschnitts vorzugsweise mindestens die Hälfte der Überlappung der benachbarten Felder.

Damit wird erfindungsgemäß die Funktion der Trennlinie, nämlich die elektrische Auftrennung der jeweiligen Funktionsschicht ohne Unterbrechung gewährleistet. Dabei werden vorzugsweise die Fangbereiche der Trennlinien aller drei Funktionsschichten möglichst in gleicher Form ausgeführt.

Die Länge des hakenförmigen Abschnitts sollte mindestens die Hälfte der Überlappung der benachbarten Felder betragen. Darüber hinaus beträgt die Länge des hakenförmigen Abschnitts vorzugsweise mindestens das Dreifache der Breite der Trennlinie.

So wird eine 100%ige Überlappung der Trennlinienabschnitte benachbarter Felder bei einer Trennlinienbreite von 50 µm und einer Genauigkeit von ± 25 µm beispielsweise durch Fangbereiche bzw. hakenförmige Abschnitte sichergestellt, die eine Breite von 100 µm und eine Länge von 500 µm aufweisen.

Durch die spezielle Form der Fangbereiche der Trennlinienabschnitte wird die Verlustfläche durch die Serienverschaltung nur sehr geringfügig größer. Betrachtet man beispielsweise ein 1,4 m² großes Solarmodul von 1100 x X 1300 mm² mit 160 Solarzellen parallel zu dem 1300 mm² breiten Substrat und einer 250 µm breiten Serienverschaltung mit 50 µm breiten Trennlinien mit jeweils 100 µm Abstand, einer Länge der Trennlinienabschnitte pro Feld von 150 mm, 500 µm langen und 100 µm breiten Fangbereichen und 8 Fangbereichen pro 1300 mm langer Trennlinie, so wird die Verlustfläche pro Serienverschaltung lediglich um ca. 0,11 % vergrößert. Dieser Flächenverlust kann bei der Gesamtbetrachtung eines photovoltaischen Moduls jedoch vernachlässigt werden.

Anliegend wird die Erfindung anhand der beigefügten Zeichnung beispielhaft näher erläutert. Darin zeigen jeweils schematisch:
Figur 1 einen Schnitt durch einen Teil eines mit serienverschalteten Zellen versehenen Substrats eines photovoltaischen Moduls, wobei die Funktionsschichten stark vergrößert wiedergegeben sind;
Figur 2 eine perspektivische Ansicht eines Laserscanners und eines Teils des beschichteten Substrats;
Figur 3 die Vorderansicht auf eine Anlage zur Erzeugung der Trennlinien in einer Funktionsschicht des Substrats;
Figur 4 eine Draufsicht auf zwei in Y-Richtung nebeneinander angeordnete Felder mit nach der eingangs erwähnten Patentanmeldung erzeugten Trennlinienabschnitten;
Figur 5 eine vergrößerte Wiedergabe des Bereiches A in Figur 4;
Figur 6 eine der Figur 4 entsprechende Draufsicht auf zwei benachbarte Felder, jedoch mit an ihrem Anfang erfindungsgemäß ausgebildeten Trennlinienabschnitten in dem einen Feld;
Figur 7 eine vergrößerte Wiedergabe des Bereichs A in Figur 6;
Figuren 8 und 9 eine der Figur 7 entsprechende Wiedergabe, jedoch von in jeweils einer anderen Ausführungsform erfindungsgemäß ausgebildeten Enden der Trennlinienabschnitte;
Figur 10 eine Draufsicht auf sich symmetrisch überlappende Enden benachbarter Trennlinienabschnitte; und
Figur 11 eine Draufsicht auf sich versetzt überlappende Enden benachbarter Trennlinienabschnitte.

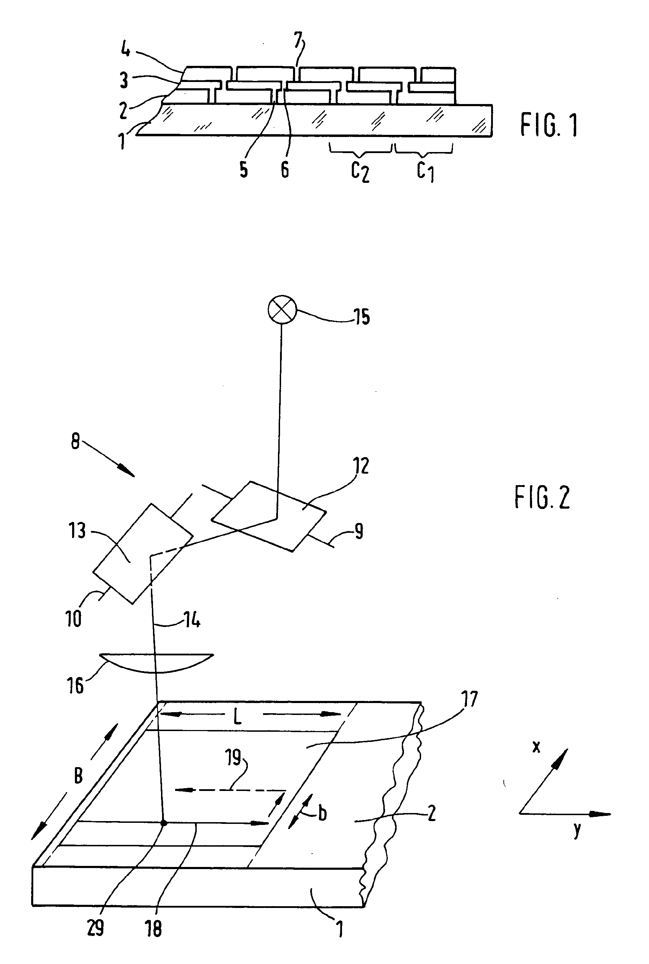

Gemäß Figur 1 weist ein transparentes Substrat 1, beispielsweise eine Glasscheibe, eine transparente Frontelektrodenschicht 2, eine Halbleiterschicht 3 und eine Rückelektrodenschicht 4 auf.

Die Funktionsschichten 2, 3 und 4 sind mit Trennlinien 5, 6, 7 versehen, um serienverschaltete streifenförmige Zellen C1, C2, ... zu bilden.

Die Trennlinien 5, 6, 7 werden mit Laserscannern 8 erzeugt.

Gemäß Figur 2 weist der Laserscanner 8 zwei um die orthogonalan Achsen 9, 10 drehbare Spiegel 12, 13 auf, über die der Laserstrahl 14 von der Laserquelle 15 zu einer Fokussieroptik 16 reflektiert wird, mit der der Laserstrahl 14 auf der Funktionsschicht, beispielsweise der Frontelektrodenschicht 2 fokussiert wird.

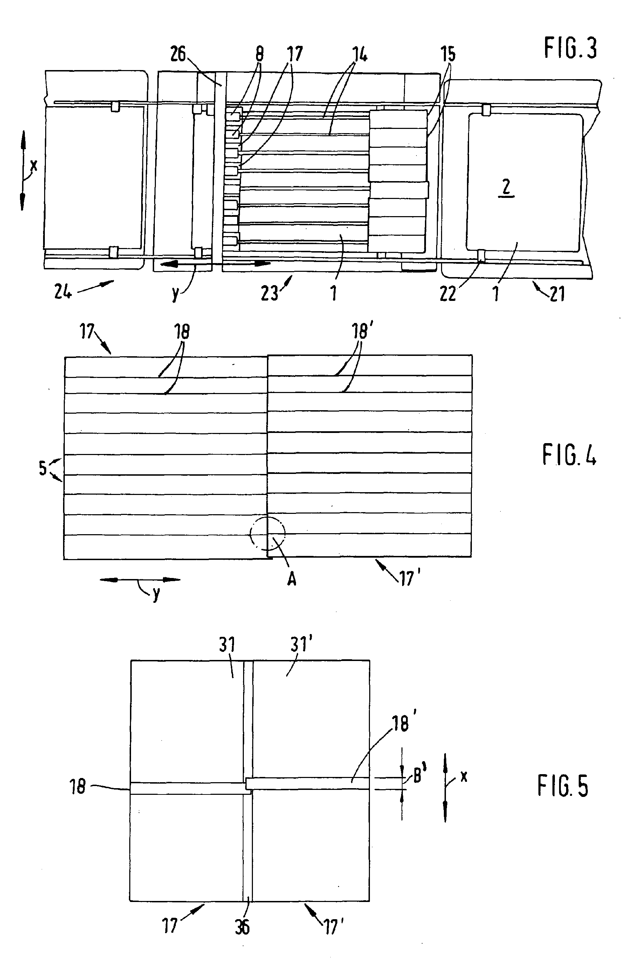

Wie in Figur 2 dargestellt, wird mit dem Laserstrahl 14 jedes Laserscanners 8 eine Fokussierfläche oder Feld 17 z. B. mit einer Länge L von 150 mm und einer Breite B von 150 mm auf der Funktionsschicht 2 abgetastet, die mit den in Y-Richtung verlaufenden Trennlinien 5 versehen werden soll (Figur 3).

Dazu ist der Laserscanner 8 mit den beiden durch jeweils einen nicht dargestellten Galvanometerantrieb betätigbare Spiegel 12, 13 versehen.

Um in dem Feld 17 eine Zeile, d. h. einen Abschnitt 18 (Figur 2) einer Trennlinien 5 zu erzeugen, wird der Spiegel 12 gedreht und dadurch der Laserstrahl 14 in Y-Richtung abgelenkt.

Nach dem Erzeugen des in Figur 2 sich über die gesamte Länge L des Feldes 17 erstreckenden Trennlinienabschnitts 18 in dem Feld 17 muss der Laserstrahl 14 auf die nächste in Figur 2 gestrichelt dargestellte Zeile 19 gelenkt werden, um den nächsten parallelen Trennlinienabschnitt in dem Feld 17 zu erzeugen.

Dazu wird zunächst der Spiegel 13 gedreht und damit der Laserstrahl 14 in die zu der Y-Richtung senkrechte X-Richtung um den Abstand b gelenkt, der dem Abstand zweier benachbarter Trennlinien 5 in der Funktionsschicht 2 entspricht. Alsdann wird wieder der Spiegel 12 betätigt, wodurch in der Zeile 19 der nächste sich über die gesamte Länge des Feldes 18 erstreckende Trennlinienabschnitt gebildet wird. Dieser Vorgang wird so oft wiederholt, bis das Feld 17 über seine gesamte Breite B mit Trennlinienabschnitten 18 versehen ist.

Gemäß Figur 3 weist eine Anlage zur Bildung der Trennlinien 5, 6, 7 eine Beladestation 21 auf, an der das beispielsweise mit der Frontelektrodenschicht 2 beschichtete Substrat 1 mit einer durch eine Klemmeinrichtung gebildeten Aufnahme 22 hochkant, gegebenenfalls auch schräg, fixiert wird.

Von der Beladestation 21 wird das Substrat 1 zu der Bearbeitungsstation 23 in Y-Richtung bewegt, an der die Trennlinien 5 in der Schicht 2 erzeugt werden, und von dort zu der Entladestation 24 auf der anderen Seite der Bearbeitungsstation 23.

Die Bearbeitungsstation 23 weist dabei acht Laserscanner 8 mit jeweils einer Laserquelle 15 auf. Die acht Laserscanner 8 sind an einer als Portal ausgebildeten Halterung 26 angeordnet und erstrecken sich damit in einer Reihe quer, d. h. in X-Richtung über das zu bearbeitende Substrat 1, dessen Schicht 2 mit den Trennlinien 5 versehen werden soll.

Jeder Laserscanner 8 gemäß Figur 3 ist im Wesentlichen so aufgebaut, wie im Zusammenhang mit Figur 2 beschrieben. Das heißt, alle acht Laserscanner 8 versehen gleichzeitig das darunter liegende Feld 17 mit sich über die gesamte Länge L jedes Feldes 17 erstreckenden Trennlinienabschnitten 18. Die einzelnen Felder 17 unter den Laserscannern 8 schließen dabei in Y-Richtung aneinander an. Damit wird das Substrat 1 über seine gesamte Breite mit in einer Reihe angeordneten parallelen Trennlinienabschnitten 18 versehen, die eine den Feldern 17 entsprechende Länge L aufweisen.

Im nächsten Schritt müssen die Laserscanner 8 relativ zu dem Substrat 1 in Y-Richtung bewegt werden und zwar um einen Abstand, der höchstens der Länge L der Felder 17 entspricht.

Alsdann wird mit den Laserscannern 8 eine zweite sich über die gesamte Breite des Substrats 1 erstreckende Reihe von parallelen Trennlinienabschnitten 18 gebildet. Dieser Vorgang wird solange wiederholt, bis die Trennlinienabschnitte 18 der einzelnen Reihen sich in Y-Richtung über die gesamte Länge des Subtrats 1 erstreckende durchgehende Trennlinien 5 in der Schicht 2 bilden.

Bemerkt sei, dass der Abstand, um den die Laserscanner 8 in Y-Richtung bei jedem Schritt bewegt werden, etwas geringer ist als die Länge der Felder 17, um eine Überlappung der Felder 17 in der Y-Richtung zu erzielen. Damit durchgehende Trennlinien gebildet werden, ist es ferner erforderlich, dass die einzelnen Trennlinienabschnitte 18 jeder Trennlinie 5 miteinander fluchten.

Dies ist in Figur 4 und 5 näher dargestellt. Dabei zeigt Figur 4 zwei in Y-Richtung aneinander anschließende Felder 17, 17' mit den Trennlinien 5, die durch die Trennlinienabschnitte 18, 18' benachbarter Felder 17, 17' gebildet werden.

Wenn die Breite B der Trennlinien z. B. 50 µm beträgt, muss eine Genauigkeit von ± 25 µm in X-Richtung eingehalten werden, ferner eine Überlappung 36, um durchgehende Trennlinien 18, 18' zu bilden.

Gemäß Figur 4 und 5 müssen also genaue Toleranzen eingehalten werden, damit sich die Enden 31, 31' der Trennlinienabschnitte 18, 18' überlappen. Dies erfordert eine äußerst präzise Justierung der Strukturierungsvorrichtung 23.

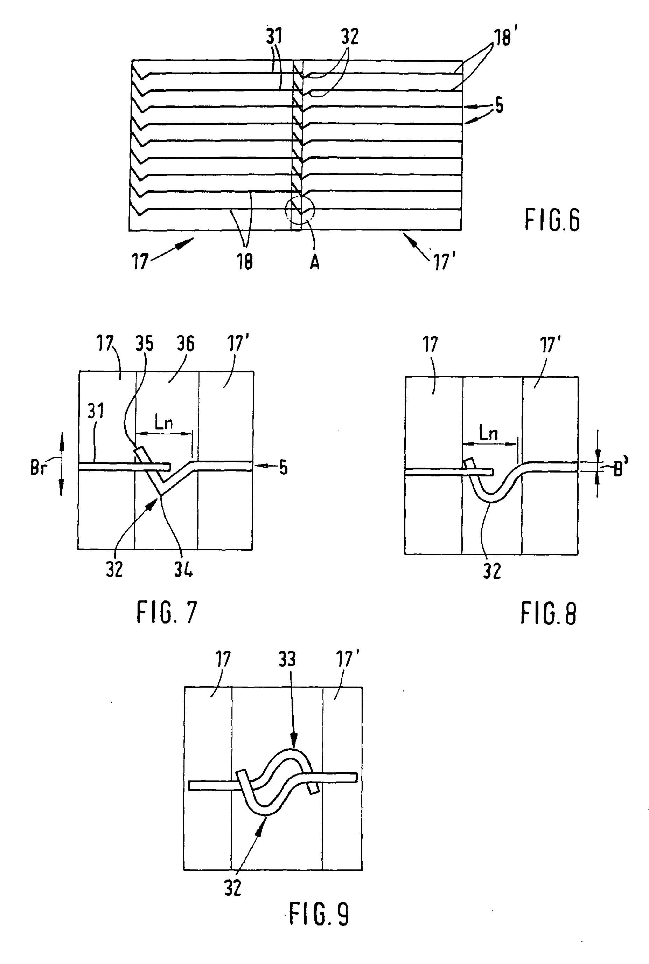

Demgegenüber werden erfindungsgemäß, wie in Figur 6 bis 8 zu sehen, durch die hakenförmigen Endbereiche 32 der Trennlinienabschnitte 18' des einen Feldes 17' der beiden überlappenden Felder 17, 17' Fangbereiche gebildet, die ein Überlappen mit dem geraden Endbereich 31 der Trennlinienabschnitte 18 des benachbarten Feldes 17 sicherstellen.

Dabei sind nach Figur 6 und 7 die hakenförmigen Endbereiche 32 abgewinkelt ausgebildet, während sie nach Figur 8 wellenförmig oder gekrümmt sind.

Während bei der Ausführungsform nach Figur 6 bis 8 nur die Endbereiche 32 der Trennlinienabschnitte 18' des einen Feldes 17' hakenförmig ausgebildet sind, sind bei der Ausführungsform nach Figur 9 beide einander überlappende Endbereiche 32, 33 hakenförmig ausgebildet.

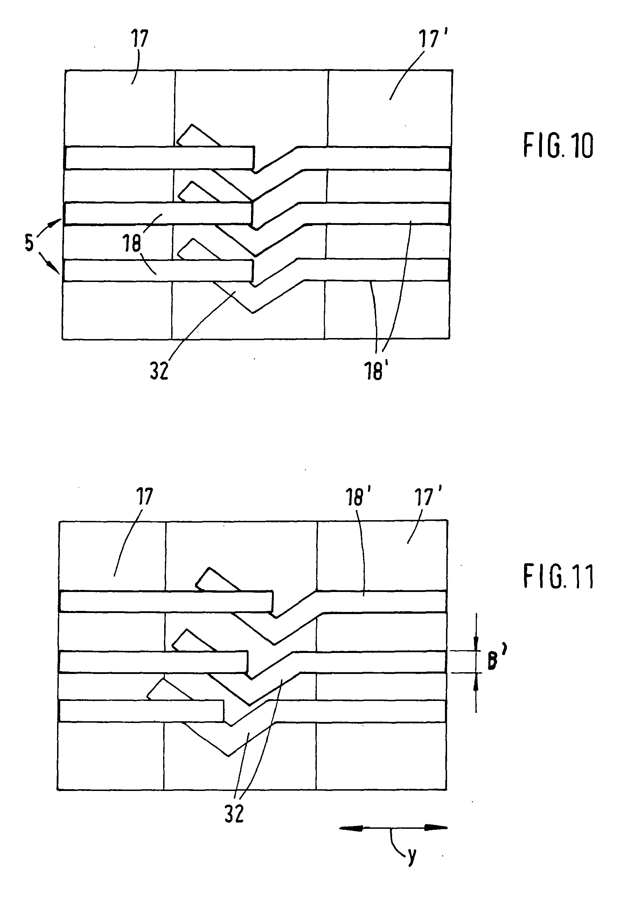

Nach Figur 10 sind die hakenförmigen Endbereiche 32 benachbarter Trennlinienabschnitte 18' parallel und damit symmetrisch ausgebildet, während sie nach Figur 11 in Y-Richtung versetzt angeordnet sind.

Wie aus Figur 7 ersichtlich, ist der Scheitelpunkt 34 des hakenförmigen Endbereiches 32 auf der einen und die Hakenspitze 35 auf der anderen Seite der Trennlinien 5 angeordnet.

Der hakenförmige Endbereich 32 weist gemäß Figur 7 eine Breite Br und eine Länge Ln auf. Die Länge Ln entspricht dabei im Wesentlichen der Überlappung 36 der beiden Felder 17, 17' bzw. etwa dem 5-fachen der Breite B der Trennlinien 5.

Damit kann bei geringen apparativen Zusatzkosten die Bearbeitungszeit zur Bildung der Trennlinien 5, 6, 7 um mehr als 70 % verringert werden.

Vorstehend ist die Strukturierung in Y-Richtung erläutert, also bei dem rechteckigen Substrat 1 in Längsrichtung. Die Trennlinien und damit die Trennlinienabschnitte können sich jedoch auch in X-Richtung erstrecken, also z. B. über die gesamte Breite des beschichteten Substrats. Dazu werden in einem Schritt mit den Laserscannern 8 sich über die gesamte Breite, also Länge des Substrats 1 in X-Richtung erstreckende durchgehende Trennlinien gebildet. Dann erfolgt eine Relativbewegung der Laserscanner 8 und des Substrats 1 in Y-Richtung um höchstens einen Abstand, der der Länge L der Felder 17 entspricht, worauf mit den Laserscannern 8 erneut sich über die gesamte Breite der Funktionsschicht des Substrats 1 erstreckende durchgehenden Trennlinien gebildet werden, usw.

Auch sei bemerkt, dass das Substrat, auf dem die Funktionsschichten abgeschieden werden, auch undurchsichtig, also nicht transparent sein kann. Das heißt, es kann eine Rückseitenabdeckung des Moduls bilden, auf der die Rückseitenelektrodenschicht, die Halbleiterschicht und dann die transparente Frontelektrodenschicht abgeschieden werden, und dann auf die Frontelektrodenschicht eine transparente Platte oder Folie aufgebracht werden.

## Patentansprüche

1. Verfahren zur Bildung von Trennlinien (5, 6, 7), wobei die Trennlinien (5, 6, 7), die bei der Herstellung eines photovoltaischen Moduls mit serienverschalteten Zellen (C1, C2, ...) in der transparenten Frontelektrodenschicht (2), der Halbleiterschicht (3) und/oder der Rückelektrodenschicht (4), die als Funktionsschichten auf einem Substrat (1) abgeschieden sind, mit wenigstens einem Laserscanner (8) erzeugt werden, dessen Laserstrahl (14) in dem von ihm abgetasteten Feld (17, 17') mehrere nebeneinander angeordnete Trennlinienabschnitte (18, 18') in der Funktionsschicht (2, 3, 4) erzeugt, wobei der Laserscanner (8) nach Abtasten des Feldes (17) relativ zu dem beschichteten Substrat (1) um einen Abstand bewegt wird, der zur Überlappung (36) eines weiteren Feldes (17') mit dem abgetasteten Feld (17) in Richtung der Trennlinien (5) führt, **dadurch gekennzeichnet, dass** mit dem Laserscanner (5) Trennlinienabschnitte (18, 18') erzeugt werden, die zumindest an einem Ende (32, 33) hakenförmig ausgebildet sind, sodass ein Fangbereich gebildet wird, in dem sich die Enden (31, 32, 33) der Trennlinienabschnitte (18, 18') benachbarter Felder (17, 17') überlappen.

2. Verfahren nach Anspruch 1, **dadurch gekennzeichnet, dass** die hakenförmigen Endbereiche (32, 33) abgewinkelt oder gekrümmt ausgebildet sind.

3. Verfahren nach Anspruch 1 oder 2, **dadurch gekennzeichnet, dass** in Querrichtung (X) der Trennlinien (5) der Scheitelpunkt (34) des hakenförmigen Endes (32, 33) auf der einen und die Hakenspitze (35) auf der anderen Seite des geraden Abschnitts der Trennlinien (5) liegt.

4. Verfahren nach einem der vorstehenden Ansprüche, **dadurch gekennzeichnet, dass** die Breite (Br) des hakenförmigen Endbereiches (32, 33) mindestens das 2-fache der Breite (b) der Trennlinien (5) beträgt.

5. Verfahren nach einem der vorstehenden Ansprüche, **dadurch gekennzeichnet, dass** die Länge (Ln) des hakenförmigen Endbereiches (32, 33) mindestens die Hälfte der Überlappung (36) der benachbarten Felder (17, 17') beträgt.

6. Verfahren nach einem der vorstehenden Ansprüche, **dadurch gekennzeichnet, dass** die Länge (Ln) des hakenförmigen Endbereiches (32) mindestens das 3-fache der Breite (b) der Trennlinien (5) beträgt.
